# EUROPEAN PATENT SPECIFICATION

(11) **EP 4 468 337 B1**
(45) Date of publication and mention of the grant of the patent: **29.10.2025**
(21) Application number: 23175649.5
(22) Date of filing: 26.05.2023
(51) Int. Cl.: H01L 23/473, H01L 25/07, H05K 7/20, H01L 23/44

(54) **SEMICONDUCTOR POWER MODULE, SEMICONDUCTOR POWER PACKAGE AND METHOD FOR MANUFACTURING A SEMICONDUCTOR POWER MODULE**
HALBLEITERLEISTUNGSMODUL, HALBLEITERLEISTUNGSPAKET UND VERFAHREN ZUR HERSTELLUNG EINES HALBLEITERLEISTUNGSMODULS
MODULE DE PUISSANCE À SEMI-CONDUCTEUR, BOÎTIER DE PUISSANCE À SEMI-CONDUCTEUR ET PROCÉDÉ DE FABRICATION D'UN MODULE DE PUISSANCE À SEMI-CONDUCTEUR

(43) Date of publication of application: 27.11.2024
(73) Proprietor: Hitachi Energy Ltd, 8050 Zürich (CH)
(72) Inventor: SOLEIMANZADEH, Reza, 5400 Baden (CH); PAVLICEK, Niko, 8041 Zürich (CH); SMIDT, Maximilien, 13008 Marseille (FR)
(74) Representative: Epping - Hermann - Fischer

(56) References cited:
- WO-A1-2022/004400
- DE-B3- 102014 213 108
- US-A1- 2023 164 963

## Description

The present disclosure is related to a semiconductor power module and a method for manufacturing a semiconductor power module. The present disclosure is further related to a corresponding semiconductor power package.

Power modules are used in automotive inverters for example and require a cooler to dissipate heat during operation. Such coolers are fixed to the power modules and may require additional components to set up a stable connection and a reliable cooling. Document DE 102014213108 B3 discloses a power module having at least one power semiconductor, in particular a semiconductor switch. The power module also has a housing which encloses a cavity. The at least one power semiconductor is arranged in the cavity enclosed by the housing. The cavity is at least partially filled with a thermally conductive medium, whereby the medium is designed to transfer heat generated by the power semiconductor to the housing.

Document US 2023/164963 A1 discloses a liquid-cooled power electronics unit includes a planar circuit board body having conductor tracks, a wet side with a wet space for carrying a dielectric cooling liquid, and a fluidically, separated dry side. At least two high-voltage power semiconductors are arranged on the circuit board body on the wet side within the wet space, the high-voltage power semiconductors being cooled by the cooling liquid, and an electronic low-voltage circuit is arranged on the dry side of the circuit board body.

There is a need to provide a semiconductor power module that contributes to reliable and effective heat dissipation of a semiconductor power module during operation.

The invention relates to a semiconductor power module according to claim 1, a corresponding semiconductor power package according to claim 12 and a method for manufacturing a semiconductor power module according to claim 14.

According to an embodiment, a semiconductor power module comprises at least one semiconductor power device having electrical terminals, e.g. for operation, a first metallic component and a second metallic component. The first metallic component is coupled to a first side of the semiconductor power device, which also can be referred to as the bottom side of the respective device. The first metallic component can be coupled directly to the bottom side of the semiconductor power device or by means of one or more intermediate elements. The first metallic component comprises a given surface structure for guiding a cooling fluid along the semiconductor power device. In particular, the given surface structure of the first metallic component is formed at a side facing the respective semiconductor power device, which also can be referred to as the top side of the first metallic component.

The second metallic component is coupled to a second side of the semiconductor power device opposite the first side with respect to a stacking direction of the semiconductor power module, which also can be referred to as the top side of the respective device, accordingly. The second metallic component can be coupled directly to the top side of the semiconductor power device or by means of one or more intermediate elements. The second metallic component can also comprise a given surface structure for guiding the cooling fluid along the semiconductor power device. In particular, the given surface structure of the second metallic component can be formed at a side facing the respective semiconductor power device, which also can be referred to as the bottom side of the second metallic component.

The semiconductor power module further comprises a control terminal that is electrically coupled to one or more electrical contacts of the semiconductor power device. Moreover, the semiconductor power module comprises a hollow housing that limits a predetermined inner flow of the cooling fluid. The housing can be formed as a frame and comprises an inlet and an outlet for the entering and exiting of the cooling fluid into and out of the housing. The housing is coupled to both the first and the second metallic component and encloses the semiconductor power device such that the housing and the first and the second metallic component form an inner flow chamber around the semiconductor power device which is configured to be filled with the cooling fluid during operation of the semiconductor power module. The first metallic component forms a plate-like bottom and/or the second metallic component forms a plate like top of the semiconductor power module with respect to the stacking direction. The first and the second metallic component can realize a respective cover at the bottom and the top of the housing and enable secure and reliable limiting of the inner flow chamber.

By use of the described configuration a semiconductor power module is feasible that contributes to reliable and effective heat dissipation during operation. The described formation of the inner flow chamber around the semiconductor power device enables an efficient immersion cooled semiconductor power module. The one or more semiconductor power devices are in direct contact with a coolant or the cooling fluid which can be realized a cooling liquid to convectively transfer heat in a single phase or the cooling can benefit from a phase change, e.g. vaporization to enhance a heat extraction efficiency. Inter alia, the semiconductor power module is suitable for use in automotive or aviator applications and/or in high voltage direct current applications (HVDC), for example for a voltage of at least 0.5 kV.

The semiconductor power module can comprise one or more semiconductor power devices, wherein a respective semiconductor power device can be formed as a metal-oxide-semiconductor field effect transistor (MOSFET) or more general as a metal-insulator-semiconductor field-effect transistor (MISFET), as a bi-mode insulated gate transistor (BIGT) or an insulated-gate bipolar transistor (IGBT) or a diode. In particular, the at least one semiconductor device comprises at least two power terminals, e.g., source and drain, or emitter and collector, and transistors and at least one gate electrically connected with the control terminal.

According to a preferred embodiment, the semiconductor power module comprises two or more semiconductor power devices each having respective electrical terminals, e.g. for operation. The first metallic component is then coupled to a respective first side of the semiconductor power devices, and the second metallic component is then coupled to a respective second side of the semiconductor power devices opposite the first sides with respect to the stacking direction. The control terminal is electrically coupled to respective electric contacts of the semiconductor power devices, and the hollow housing encloses the semiconductor power devices such that the housing and the first and the second metallic component form an inner flow chamber around the semiconductor power devices which is configured to be filled with the cooling fluid during operation of the semiconductor power module.

The described configuration allows for a beneficial set up and efficient heat dissipation of the semiconductor power module with multiple semiconductor power devices. During operation, the respective semiconductor devices are in direct contact with an insulating coolant that fills the given space inside the semiconductor power module and flows around the semiconductor power devices.

Power semiconductor modules are essential components of power converters and comprise power semiconductor devices and these devices dissipate electrical energy in form of heat during the operation resulting in a temperature rise in the module. With the increasing power densities in many power-electronic applications and moving from conventional silicon (Si) devices to semiconductors with higher power density capability such as silicon carbide (SiC), an efficient and reliable thermal management is required to comply with the cooling demands and to enable features such as overload capability.

It is a finding in the context of the present disclosure that in conventional module packaging and cooling schemes, the heat generated at the semiconductor device must be conducted through many layers of the packaging, e.g. including chip bonding material, a substrate and a substrate bond, a baseplate, a cooler and its thermal interface material (TIM) before reaching to a cooling liquid to be extracted out of the module. In addition, in many high voltage or high power applications such as HVDC systems, where water or water-glycol mixtures are used for the cooling, the heat sinks are often designed conservatively using thick metallic layers to mitigate a risk of rupture and water leakage caused by arcing or explosions in failure cases. However, relatively large cooler thickness result in increasing the thermal resistances and limiting the heat extraction capability. Conventional cooling approaches suffer from the high thermal resistances between the hot spots and the cooling liquid.

Therefore, the cooling of power modules is an essential part of the design of a system to ensure the power modules or the semiconductors do not fail, and the characteristics of the semiconductor devices and the power module are maintained within the expected ranges. According to the described configuration of the power module, a thermal resistance can be minimized or at least reduced significantly by bringing the cooling fluid as close as possible to the chips or the semiconductor power devices. Leveraging such an immersion cooling for power electronics can enable to achieve the full potential of the semiconductors devices by minimizing or reducing thermal limits. An internal space of the semiconductor power module around, above and below the semiconductor devices can be filled with the cooling fluid. The described power module design enables a real immersion cooling and efficient heat removal out of the semiconductor power module.

According to a further embodiment of the semiconductor power module, the housing is electrically insulating with a predetermined dielectric strength and is made of or comprise polyether ether ketone, PEEK, and/or polytetrafluoroethylene, PTFE, ceramic and/or an epoxy-based mold compound.

According to a further embodiment of the semiconductor power module, the control terminal and/or the second metallic component are made of or comprise copper and/or aluminium and/or a corresponding alloy. The second metallic component can also serve as power busbar on, e.g., source or emitter potential. Additionally, the second metallic component can be galvanized and/or can comprise a surface finish with, e.g. nickel.

According to a further embodiment of the semiconductor power module, the first metallic component is made of or comprise molybdenum and/or copper and/or aluminium and/or a corresponding alloy. The first metallic component can further serve as a baseplate of the semiconductor power module. Additionally, the first metallic component can be galvanized and/or can comprise a surface finish with, e.g. nickel.

According to a further embodiment, the semiconductor power module comprises at least one metallic spring that electrically connects a respective electrical contact of the associated semiconductor power device with the control terminal. Such metallic spring elements can realize a secure and reliable spring loaded contact between the control terminal and the respective semiconductor power devices. The metallic spring connects one or more top side power terminals of the respective semiconductor device to the control terminal and/or the second metallic component.

The springs loaded contacts can be formed by one or more metallic springs, sleeves, and/or plungers made of or comprising at least one of stainless steel, copper, copper alloys with or without plated surfaces with gold and/or nickel, for example. A respective spring loaded contact or metallic spring can have an overall length between 5 mm to 20 mm, e.g. 9.6 mm or 12.8 mm with respect to an elongated extension. A diameter of the metallic spring or spring loaded contact can have a value between 5 mm to 0.5 mm, for example 3.89, 3.18, or 1 mm at a landing part and 1.27 mm at a plunger, for example. The metallic spring or spring loaded contact can be configured to make electrical contacts with resistances below 100 mΩ, e.g. 20 mΩ with stroke forces higher than 10 g, for example 120 g or 25 g. Furthermore, the metallic spring or spring loaded contact can be configured to carry currents between 1 A to 200 A, for example 9 A.

The semiconductor power module preferably comprises at least one transistor device, and additionally further metallic springs that connect a top side of the control terminal of the transistor device. Moreover, the semiconductor power module can comprise an electric circuit component, e.g. made from a printed circuit board (PCB), that connects to the metallic springs connecting the control terminal and feeding them out of the semiconductor power module. An external PCB feed-out of the control terminals is preferably sealed, e.g., between the first metallic component and the electrically insulating housing.

According to a further embodiment of the semiconductor power module, the inlet and the outlet of the housing are arranged at the same side of the housing such that the inner flow chamber and the inlet and the outlet form a U-shaped flow volume inside the semiconductor power module. Alternatively, the inlet and/or outlet can be different depending on the application. The inlet and/or outlet can be arranged on different sides or faces of the semiconductor power module not forming a U-shape.

According to a further embodiment of the semiconductor power module, the given surface structure of the first metallic component is formed at its top side facing the semiconductor power device and comprises a plurality of ribs and grooves formed alternately side by side with respect to a lateral direction perpendicular to the stacking direction. The first metallic component can also serve as a power busbar on, e.g., drain or collector potential and the given surface structure can comprise the aforementioned and/or other machined structures to engineer the flow of the cooling liquid.

Alternatively or additionally, the given surface structure of the second metallic component can comprise protrusions and/or recesses as well to provide predetermined flow characteristics of the coolant inside the semiconductor power module during operation. Such a surface structure would be formed at the bottom side of the second metallic component facing the semiconductor power device. Alternatively, the surface structure of the second metallic component can be given such that it completely or predominantly realizes a flat surface at its bottom.

According to a further embodiment, the semiconductor power module comprises at least one sealing member that is arranged between the housing and the first and/or the second metallic component with respect to the stacking direction such that an inner area of the housing is sealed against an outer area of the housing. Such a sealing member can be realized as a ring gasket, e.g. made from rubber. Alternatively or additionally, interfaces between the metallic components and the insulating housing are sealed by an adhesive.

According to a further embodiment of the semiconductor power module, the second metallic component comprises a recess formed at its bottom side facing the semiconductor device formed geometrically in coordination with the control terminal such that the control terminal is arranged inside the recess between the second metallic component and the respective semiconductor power device with respect to the stacking direction. Such a configuration allows for a stable and secure arrangement of the electrical connection between the control terminal and the electrical contacts or terminals of the respective semiconductor power devices. In addition, the described structure can be formed relatively flat.

According to an embodiment, a semiconductor power package comprises an embodiment of the described semiconductor power module, and a cooling fluid that is configured to flow through the inner flow chamber of the semiconductor power module and around the respective semiconductor power device during operation. The cooling fluid can be selected to comprise a dielectric strength above or equal to 10 kV/mm, e.g. 14, 17, 27 or 30 kV/mm which can be measured for example by D 1816 method or by IEC 60156 method.

Alternatively or additionally, the cooling fluid can be selected to comprise a thermal conductivity in a range of 0.05 to 0.5 W/m·K, e.g. 0.06 or 0.12 or 0.15 W/m·K at room temperature.

Alternatively or additionally, the cooling fluid can be selected to comprise a boiling point above 100 °C relating to a pressure at 1 atm, for example equal or above 128, 165, 165, 167 °C or higher than 300 °C for single phase liquid cooling and between 40 °C to 125 °C, for example 49, 61, 76 or 98 °C for two phase cooling including liquid and vapor phase.

Alternatively or additionally, the cooling fluid can be selected to comprise a viscosity less than or equal to 50 cSt, e.g. 20 or 0.77, 0.71, 0.41, 0.38 or 0.40 cSt.

Alternatively or additionally, the cooling fluid can be selected to comprise a specific heat above or equal to 700 J/kg·K, for example 1040, 1128, 1140, 1220, 1183, 1103, 1300, 1880, or 2170 J/kg·K.

It is a finding of the present disclosure that the aforementioned parameters of a coolant beneficially affect the heat dissipation in view of a use inside the described flow chamber of the immersed semiconductor power module.

As a result of that the described semiconductor power package comprise an embodiment of the semiconductor power module, described features and characteristics of the semiconductor power module are also disclosed with respect to the semiconductor power package and vice versa.

According to an embodiment, a method for manufacturing an embodiment of the semiconductor power module comprises providing one or more semiconductor power devices, the first metallic component and the second metallic component and providing the hollow housing as well as the control terminal. The method further comprises coupling the respective semiconductor power device and the first metallic component to each other such that the first metallic component is coupled to the respective first side or bottom side of the associated semiconductor power device. The method further comprises coupling the respective semiconductor power device and the second metallic component to each other such that the second metallic component is coupled to the second side or top side of the semiconductor power device opposite the first side. The method further comprises coupling the control terminal electrically to a respective electrical contact of the associated semiconductor power device, e.g. by means of one or more metallic springs. The method further comprises coupling the housing to both the first and the second metallic component such that the housing encloses the semiconductor power device and such that the housing and the first and the second metallic component form an inner flow chamber around the one or more semiconductor power devices which is filled with the cooling fluid during operation of the semiconductor power module.

The described manufacturing method enables production of the aforementioned semiconductor power module. The described sequence of manufacturing steps can vary and is not predefined. For instances, the coupling of the control terminal is preferably done beforehand the coupling of the second metallic component as a top cover of the housing. However, as a result of that the described method is configured for manufacturing an embodiment of the semiconductor power module, described features and characteristics of the semiconductor power module are also disclosed with respect to the manufacturing method and vice versa.

The described embodiments of the semiconductor power module with immersion cooling each combine an electric circuit and thermal management in a single module. The immersion cooling allows to provide direct double-sided cooling for the semiconductor devices, and there is no need for any external coolers. However, external cooler can be attached additionally to further improve the heat dissipation. The insulating cooling fluid can flow inside the power module to be in direct contact with the heat generating components, in particular the semiconductors, or as close as possible to hot spots of heat generation to extract the heat with a minimal heat conduction path. Heat can be transferred convectively in a single phase, e.g. liquid, or it can benefit from a phase change, e.g. vaporization, to enhance the heat extraction, and the predetermined fluid flow allows high heat extraction capability at higher flow rates.

As a result of that, thermal resistances can be significantly reduced compared to conventional cooling set ups. The semiconductor power module is configured in coordination with the immersion cooling to achieve compactness and high performances. Many components in the semiconductor power module are co-designed with multiple functionalities:
a. The electrical contacts to the semiconductor devices can have pin, fin, or channel shapes to allow better cooling. Therefore, the electrical contacts can be formed by pressure contacts for example spring-loaded contacts.
b. The semiconductor power module can comprise a baseplate with embedded fins or channels for cooling.
c. The semiconductor power module housing is designed to serve as a manifold for flow distribution, the cooling channel, as well as electrical insulation and to provide mechanical integrity.
d. The refrigerant or coolant can be selected from insulating ones to act as the dielectric encapsulation.
e. The surfaces can comprise a given surface structure treated in such a way to enhance the nucleation when two-phase cooling approach is used.

Exemplary embodiments are explained in the following with the aid of schematic drawings and reference numbers. The figures show:
Figures 1-8 an embodiment of a semiconductor power module or components thereof in perspective views;
Figures 9-15 characteristics of the semiconductor power module or components thereof in different views; and
Figure 16 a flow chart for a method for manufacturing a semiconductor power module according to the Figs. 1-15.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in the figures, the description thereof is not repeated for each of the following figures. For the sake of clarity elements might not appear with corresponding reference symbols in all figures, possibly.

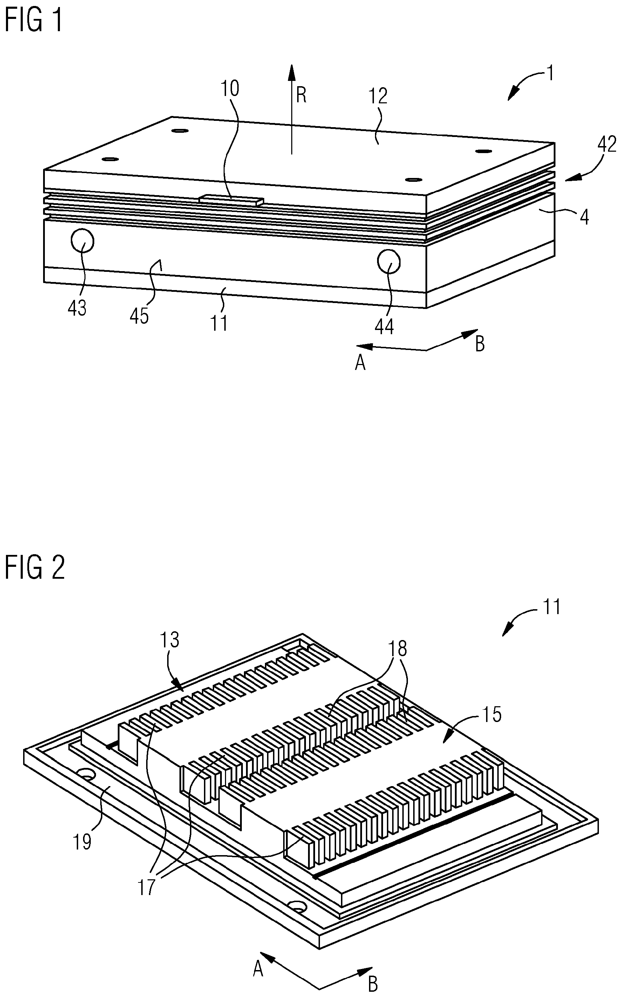

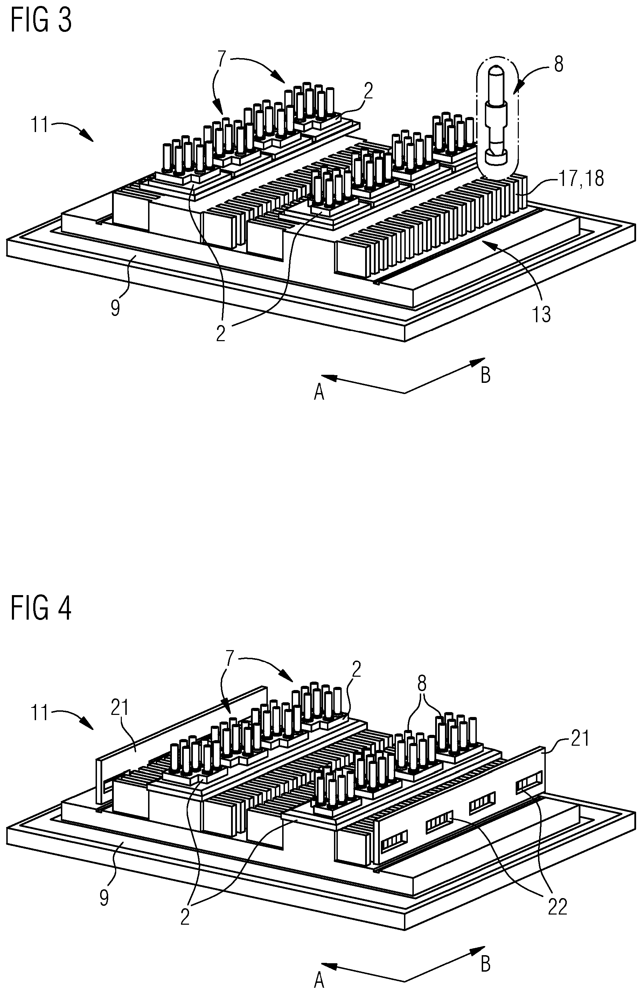

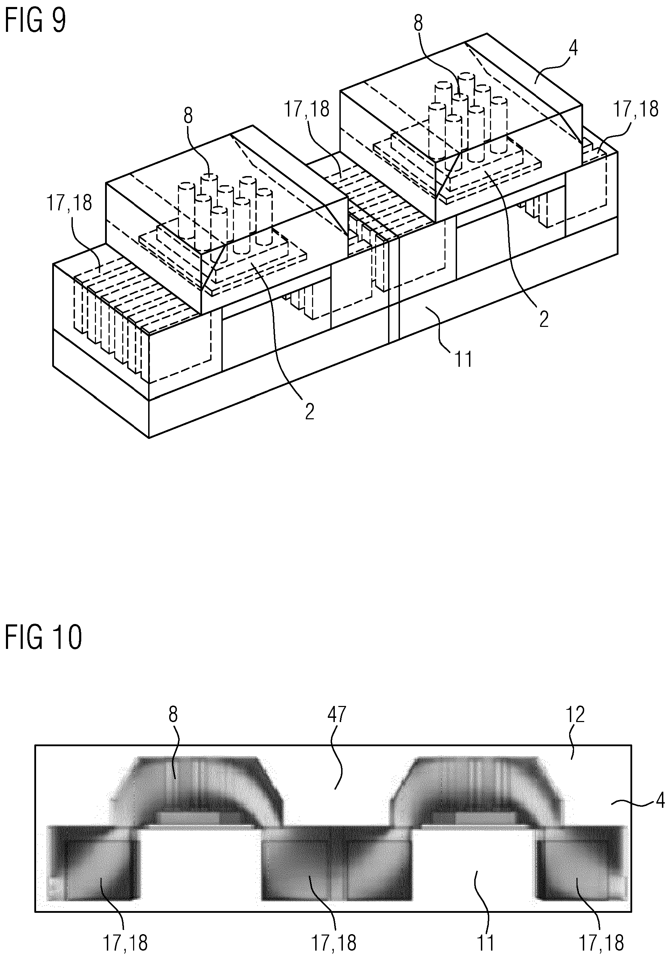

The figures 1 to 8 show embodiments of a semiconductor power module 1 or components thereof in different views. The figures 9-15 illustrate characteristics of the semiconductor power module 1 or components thereof in different views. The semiconductor power module 1 (hereafter abbreviated as module 1 can form a subunit of a semiconductor power stack or package with a given cooling liquid or coolant and/or with multiple of modules 1. The module 1 comprises multiple semiconductor power devices 2 (hereafter abbreviated as devices 2) enclosed in a housing 4 each having respective electrical terminals or contacts for operation. According to the illustrated embodiments, the module 1 comprises eight devices 2 (see Figs. 3 and 4). For example, the devices 2 can be realized as an IGBT, MOSFET/MISFET or BIGT with power and/or control terminals, e.g. drain, source, and gate or collector, emitter, and gate, respectively.

The module 1 further comprises a first metallic component 11 coupled to a respective first side 5 of the devices 2. With respect to a stacking direction R of the module 1, the first side 5 can also be referred to as a bottom side of the respective device 2. Thus, the respective bottom side of the devices 2 is attached to a top surface 15 of the first metallic component 11 (see Fig. 2). The first metallic component 11 comprises a given surface structure 13 with a plurality of ribs 17 and grooves 18 formed alternately side by side with respect to a lateral direction B perpendicular to the stacking direction R (see Figs. 2-4). The surface structure 13 is formed for predetermined guiding the cooling fluid along the devices 2.

The module 1 further comprises a second metallic component 12 coupled to a second side 6 of the respective devices 2 opposite the first side 5 with respect to the stacking direction R. With respect to the stacking direction R, the second side 6 can also be referred to as a top side of the respective device 2. According to the illustrated embodiments of the module 1, the second metallic component 12 is coupled to the top side 6 of the devices 2 by means of a control terminal 10 and electrical contacts 7 of the devices 2 comprising multiple metallic springs 8 (see Figs. 3-4 and 7-8 and inset of Fig. 3).

The second metallic component 12 comprises a given surface structure 14 for guiding the cooling fluid along the devices 2. The second metallic component 12 forms a top cover of the module 1 and the surface structure 14 is substantially flat except a recess 20 for receiving the control terminal 10 and one or more bore holes for assembling the module 1.

Alternatively, the surface structure 14 of the second metallic component 12 can comprise pin fins or any other protruding or recessed structure beneficial for cooling.

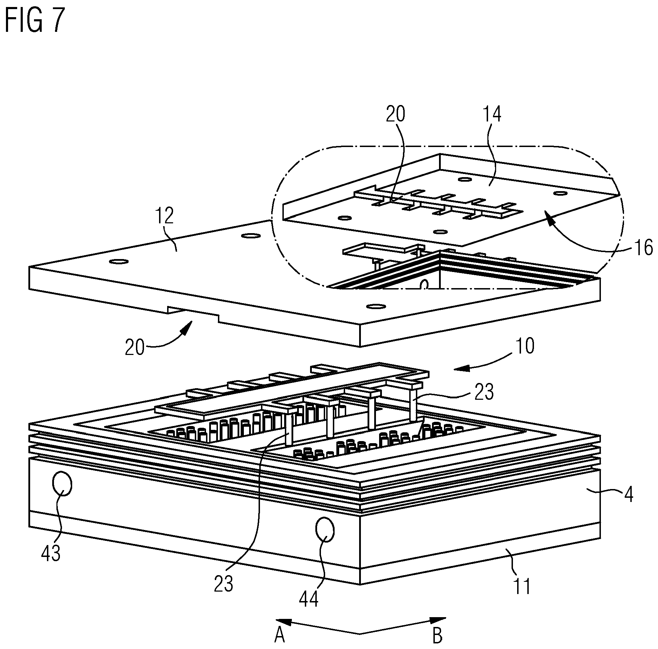

The control terminal 10 is formed as a printed circuit board and is electrically coupled to the electrical contacts 7 of the eight devices 2 by means of corresponding metallic springs 23 which are configured to connect with the metallic springs 8 of the devices 2. The control terminal 10 is arranged inside a corresponding recess 20 of the second metallic component 12 which is formed at its bottom surface 16 (see inset of Fig. 7).

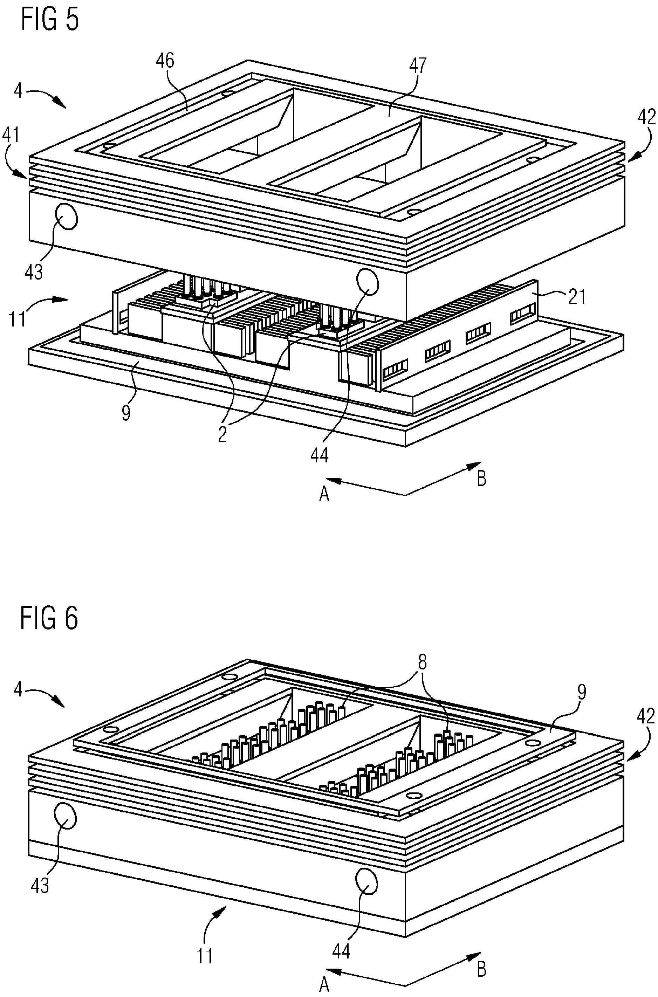

The module 1 further comprises the hollow housing 4 which is formed as a rectangular frame including four side walls and an inner wall 47 to realize and limit a predetermined guiding flow of the cooling fluid inside the module 1 during operation. The housing 4 comprise an inlet 43 and an outlet 44 for the entering and exiting of the cooling fluid into and out of the housing 4. The inlet 43 and the outlet 44 are formed at the same side wall 45 of the housing 4 realizing a U-shaped inner flow volume basically (see Figs. 5 and 6).

The housing 4 is coupled to both the first and the second metallic component 11, 12 and encloses the devices 2 such that the housing 4 and the first and the second metallic component 11, 12 form an inner flow chamber around the devices 2 which is configured to be filled with the cooling fluid during operation of the module 1. The housing 4 comprises a circumferential edge 41 with a plurality of creepage ribs 42 above the inlet 43 and the outlet 44 and below the second metallic component 12.

The first metallic component 11 realizes a bottom cover and the second metallic component 12 realizes a top cover attached to the housing 4. For secure and reliable sealing of an inner volume of the housing 4 against an outer volume, the module comprises sealing elements 9 which are arranged in respective sealing recesses 19 and 46 of the first metallic component 11 and at a top of the housing 4 (see Figs. 2-8). In order to further control the inner flow of the cooling fluid, the module 1 further comprises two flow guiding plates 21 arranged inside respective grooves of the first metallic component 11 at opposite sides of the devices 2 with respect to the lateral direction A. The flow guiding plates 21 comprise given recesses 22 to allow predetermined entering and exiting of the cooling fluid into and out of the volume around the devices 2. It is a finding that such guiding elements beneficially affect the heat dissipation of the heat generated by the devices 2 during operation of the module 1.

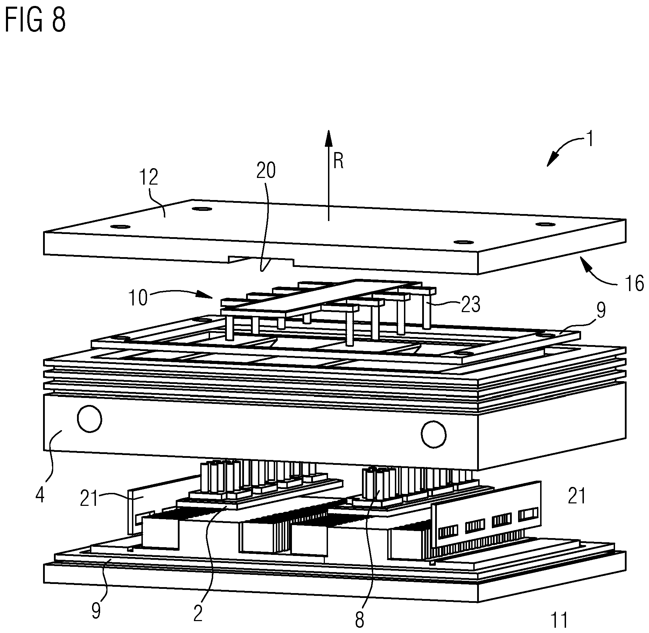

An assembled overall structure of the module 1 is shown in Figure 1. It basically has a cuboid shape, and the devices 2 are sandwiched between two metal plates as emitter and collector or source and drain connection formed by the first and the second metallic component 11 and 12. A gate contact together with an auxiliary emitter or source is realized by the control terminal 10 resembling a PCB circuit. Figure 8 shows an exploded view of the components of the module 1.

The module 1 allows internal flow of cooling fluid and comprises of several parts that have multiple functionalities. The first metallic component 11 forms a base plate (see Fig. 2) that also forms a collector plate of the module 1 and has a fins or channels that either stop below the devices 2 or are extended even under the semiconductor chips or devices 2. Thus, according to an embodiment the grooves 18 can be formed such that they form no channels below devices 2. Therefore, the cooling fluid flows between the baseplate ribs 17, then hits a wall and makes a turn to flow above the devices 2 in between the top-side contacts formed by the electrical contacts 7 and the metallic springs 8 and 23.

The devices 2 can be pre-packaged, e.g. PCB embedding or molding to increase a contact surface area and for top-side contacts 7 such as pin-shaped pressure contacts which can be realizes as commercially known Pogo pins. The devices 2 may be pre-packaged also to have metal contacts, for example suited for attachment to the first or second metallic components 11, 12, in terms of thermal expansion or solder/sinter ability, or ease of manufacturability. Additionally pre-packaging may be done to provide enough isolation around the edges of the devices 2 or a junction termination of the devices 2, or to protect potential pollutions in the cooling fluid.

To distribute the cooling flow uniformly, a manifold section at the inlet 43 and outlet 44 can be considered with flow distribution pieces formed by the flow guiding plates 21 (see Fig. 4). The dimensions of the openings or recesses 22 can be adjusted to ensure either flow uniformity or to facilitate flow rate on the hotter devices 2, for example. Dimensions can be also adjusted to prevent fluid backflow in boiling flow regimes in case of two-phase cooling.

The housing 4 attaches to the first metallic component 11 and seals with a gasket realizing the sealing member 9 and/or a permanent glue. The housing 4 comprises dents realized by the ribs 42 on an outside to comply with the creepage distance requirements and enough electrical isolation for the blocking voltage of the module 1. The housing 4 also contributes to create a three-dimensional flow of the cooling fluid inside the module 1 creating a thermally developing flow at higher flow rates, to increase the local Nusselt number.

The control terminal 10 forms a gate runner attached to the emitter plate from one side (auxiliary emitter) realized by the second metallic component 12. At the other side it contacts the gates on the devices 2 using the metallic spring contacts 8 and 23. The emitter plate or second metallic component 12 has engravings for attaching the control terminal 10 (see inset of Fig. 7) to form a flat surface and ensure proper sealing after the module 1 is fully assembled.

The cooling liquid or fluid is insulating with enough breakdown field depending on the given module voltage class, and it can be selected from a wide variety of options for example transformer oils, insulation oil, or engineered fluids for single phase or two-phase cooling.

The figures 9-15 show characteristics of the module 1. A performance of the module 1 is calculated by COMSOL simulations (see Figs. 9-12) and have been performed with following boundary conditions as an example:
- The properties in the Novec 7500 datasheet are used for the cooling fluid. In this respect, it is referred to the 3M^{®} Novec^{™} Heat Transfer Product Line Card "Heat transfer applications using 3M^{™} Novec^{™} Engineered Fluids" and "3M^{®} Novec^{™} 7500 Engineered Fluid".
- The inlet temperature of the cooling fluid is 40 °C.
- The outlet pressure of the cooling fluid is 1 atm.
- The top and bottom plates 11, 12 are made of an Al alloy.
- The devices are Si-IGBTs and sintered to a Mo-plate at the bottom (collector) side and to another Mo-plate (on the emitter side) with Pogo pins attached to them.

- The Pogo pins are made of a Cu/Be alloy.
- The housing 4 is made of PEEK.
- Thermal resistances are calculated at 100 W per device 2 of power dissipation.
- The flow rate of the cooling fluid is varied.

Figure 9 shows 3D-model of two adjacent devices 2 that was simulated in COMSOL. Figure 10 illustrate in a cross section a flow velocity profile. Higher flow velocity is present in the middle and at entrances and outputs of the devices 2 in particular. Lower flow velocity is present at wall or edges.

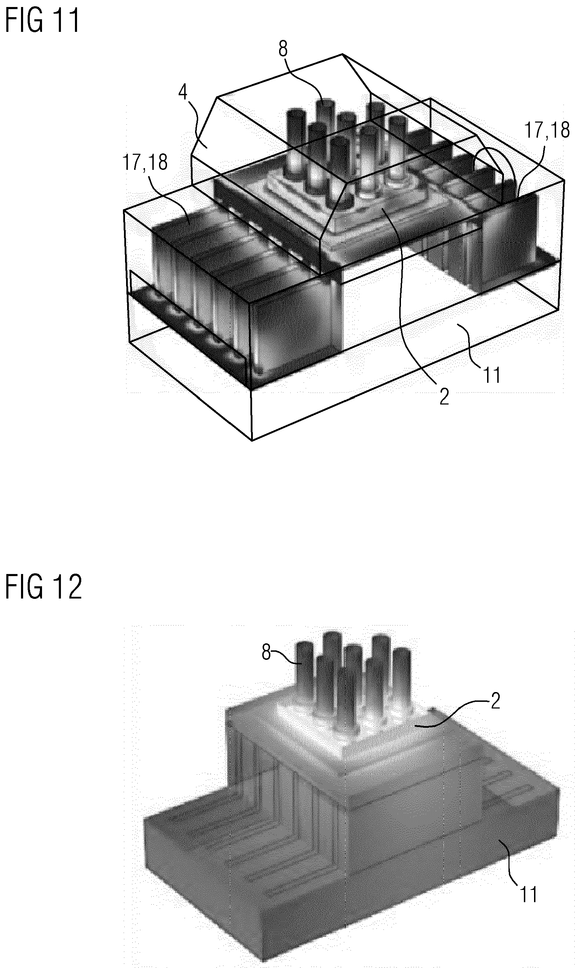

Figure 11 shows a heat flux at interface between solid and fluid. Higher heat flux is present close to the device 2 and at the interfaces of the metallic springs 8 and the device 2 in particular. Figure 12 shows a corresponding temperature profile, wherein the highest temperature is present at the device 2, consequently.

In the immersion-cooled concept of module 1, to have same level of current scalability, eight chips or devices 2 can be packaged as a subunit. However, depending on the application or yield the number of devices 2 per module 1 can be different. However, the simulation results have been scaled to equal number of devices 2 in four staked modules 1, i.e. eight chips per module 1 and thirty-two in total.

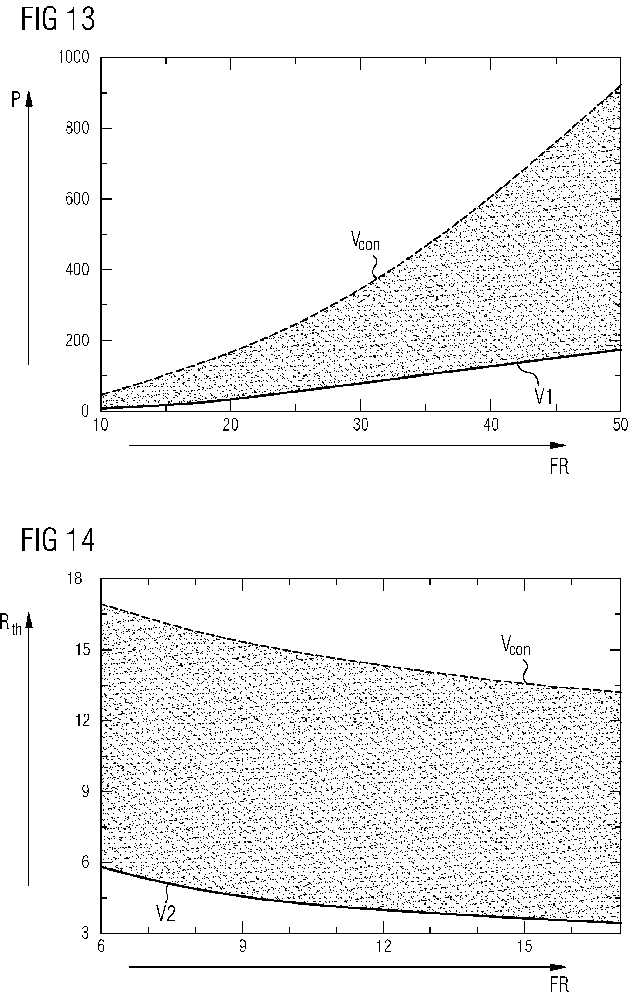

In the figures 13 and 14, characteristics V1 and V2 of the module 1 are compared to conventional set ups represented by V_{con}. The conventional set ups comprise coolers attached at two sides of a power module, each having a pressure drop between coolant inlet and outlet as shown in Figure 13. Therein, the pressure P, e.g. in mbar, of the cooling fluid is plotted against the flow rate FR, e.g. in l/min, of the cooling fluid. The function curve V1 in Fig. 13 is assigned to the described module 1. It is possible to parallel connect four immersion cooled modules 1 each with eight devices 2 electrically, whereas the fluid connection to be two in parallel and two in series. According to such a configuration, the total pressure drop remain the same as the pressure drop of a single module 1 at the same flow rate. Due to much lower pressure drops in the immersion cooled modules 1 a significant reduction of pumping demands is expected (see Fig. 13). Accordingly, in the configuration of the module 1 there is no need for an additional pump and less pumping can be used.

The function curve V2 in Fig. 14 is assigned to the described module 1. Therein, a thermal resistance Rₜₕ, e.g. in K/kW, is plotted against the flow rate FR, e.g. in l/min, of the cooling fluid representing a junction-to-inlet thermal resistance. The thermal resistance Rₜₕ of the immersion cooling module 1 is about 80% lower than the one of conventional set ups V_{con} and that can be leveraged to increase a current rating of the devices 2.

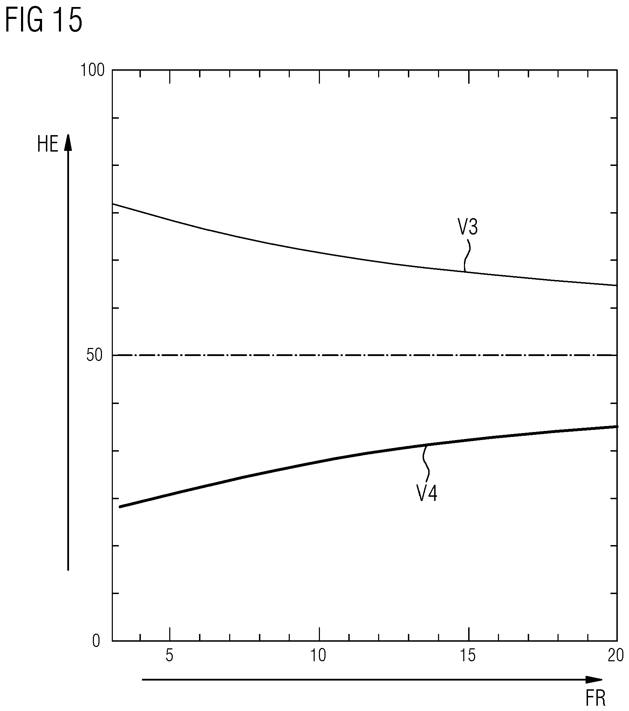

In the aforementioned conventional set up, the two coolers can be employed for double-sided cooling, but an emitter side cooler typically extracts less than 20% of the total heat. According to a relative heat extraction ratio at two sides of a respective device 2 as shown in Fig. 15, the described configuration of the module 1 allows for an equilibrated heat dissipation at the top (function curve V4) and the bottom (function curve V3) of the devices 2.

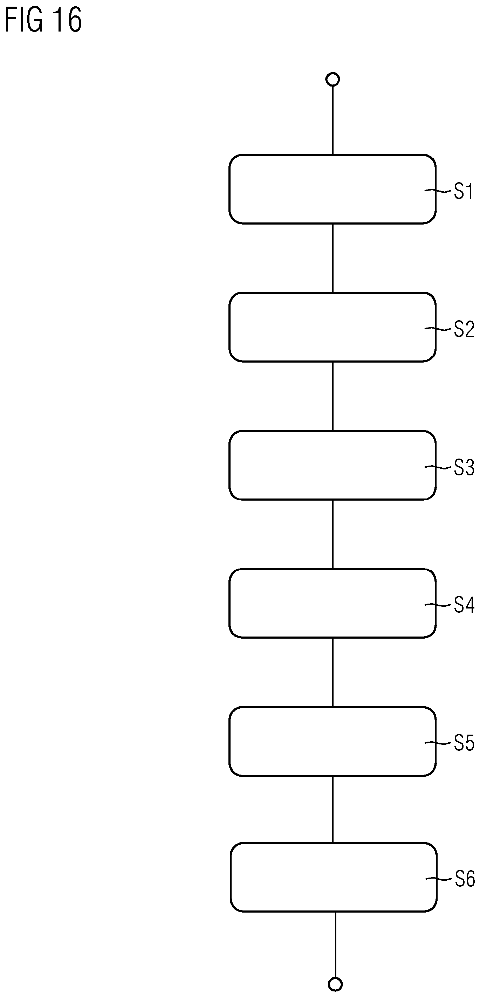

The Figs. 2-8 show in perspective views manufacturing steps for assembling the embodiment of the module 1 as shown in the Fig. 1. Such a process can be formed according to the flow chart for a method for manufacturing an embodiment of the module 1 as illustrated in Fig. 16.

In a step S1, the components of the module 1 can be provided.

In a further step S2, the devices 2 are coupled to the top surface 15 of the first metallic component 11 by means of sintering, for example, such that the first metallic component 11 is coupled to the respective bottom sides 5 of the devices 2.

The devices 2 can be provided with the metallic springs 8 which can be attached to the top side of the devices 2, for example by soldering directly and/or using an intermediate metal plate.

In a further step S3, the sealing member 9 is placed in the associated recess 19 of the first metallic component 11 and the flow guiding plates 21 are arranged at opposite sides of the devices 2.

In a further step S4, the housing 4 is coupled to the first metallic component 11 such that the housing 4 encloses the devices 2.

In a further step S5, a further sealing member 9 is placed in the associated recess 46 of the housing 4 and the control terminal 10 is attached to the devices 2 such that the metallic springs 23 of the control terminal 10 connect with the metallic springs 8 of the electrical contacts 7 or the devices 2, respectively.

In a further step S6, the second metallic component 12 is coupled to the housing 4 such that the control terminal 10 is arranges inside the associated recess 20 at the bottom surface 16 of the second metallic component 12. The first and the second metallic component 11 and 12 can be attached to the housing 4 by means of screwing and/or gluing, for example. Accordingly, the second metallic component 12 is coupled to the respective top sides 6 of the devices 2 opposite the bottom sides with respect to a stacking direction **R.**

The module 1 is assembled such that the housing 4 and the first and the second metallic component 11, 12 form an inner flow chamber around the devices 2 which is filled with the cooling fluid during operation of the module 1.

The described module 1 with an immersion cooling concept not only eliminates the need for any external coolers, but also provides improved heat extraction from both sides of the devices 2 with a single cooling component. The direct contact with a coolant or insulating refrigerant results in compactness and higher cooling efficiency, which can enable the application of new semiconductor devices with high current density such as SiC and alleviates thermal limits in future HVDC applications. In addition, the configuration of the module 1 can be leveraged to reduce the semiconductor area, cooling demand, and total module dimensions in various applications.

### Reference Signs

- 1: semiconductor power module
- 2: semiconductor power device
- 4: housing
- 41: circumferential edge of the housing
- 42: creepage ribs of the housing
- 43: inlet of the housing
- 44: outlet of the housing
- 45: sidewall of the housing
- 46: sealing recess of the housing
- 47: inner wall of the housing
- 5: first side of the semiconductor power device
- 6: second side of the semiconductor power device
- 7: electrical contact of the semiconductor power device
- 8: metallic spring of the semiconductor power device
- 9: sealing member
- 10: control terminal
- 11: first metallic component
- 12: second metallic component
- 13: surface structure of the first component
- 14: surface structure of the second component
- 15: top surface of the first metallic component
- 16: bottom surface of the second metallic component
- 17: ribs of the first metallic component
- 18: grooves of the first metallic component
- 19: sealing recess of the first metallic component
- 20: recess of the second metallic component
- 21: flow guiding plate
- 22: recess of the flow guiding plate
- 23: metallic spring of the control terminal

- A: lateral direction of the semiconductor power module
- B: lateral direction of the semiconductor power module
- HE: heat extraction
- FR: flow rate
- P: pressure
- R: stacking direction of the semiconductor power module
- Rₜₕ: thermal resistance
- S(i): step of a method for manufacturing a semiconductor power module
- V(i): function curve
- V_{con}: conventional function curve

## Claims

1. Semiconductor power module (1), comprising:
- at least one semiconductor power device (2) having electrical terminals,
- a first metallic component (11) coupled to a first side (5) of the semiconductor power device (2), wherein the first metallic component (11) comprises a given surface structure (13) for guiding a cooling fluid along the semiconductor power device (2),
- a second metallic component (12) coupled to a second side (6) of the semiconductor power device (2) opposite the first side (5) with respect to a stacking direction (R) of the semiconductor power module (1), wherein the second metallic component (12) comprises a given surface structure (14) for guiding the cooling fluid along the semiconductor power device (2),
- a control terminal (10) electrically coupled to an electrical contact (7, 8) of the semiconductor power device (2), and
- a hollow housing (4) limiting a predetermined inner flow of the cooling fluid, wherein the housing (4) comprises an inlet (43) and an outlet (44) for the entering and exiting of the cooling fluid into and out of the housing (4), and wherein the housing (4) is coupled to both the first and the second metallic component (11, 12) and encloses the semiconductor power device (2) such that the housing (4) and the first and the second metallic component (11, 12) form an inner flow chamber around the semiconductor power device (2) which is configured to be filled with the cooling fluid during operation of the semiconductor power module (1), **characterized in that** the first metallic component (11) forms a plate-like bottom and/or the second metallic component (12) forms a plate like top of the semiconductor power module (1) with respect to the stacking direction (R).

2. Semiconductor power module (1) according to claim 1, comprising:
two or more semiconductor power devices (2) each having electrical terminals,
wherein the first metallic component (11) is coupled to a respective first side (5) of the semiconductor power devices (2), wherein the second metallic component (12) is coupled to a respective second side (6) of the semiconductor power devices (2) opposite the first sides (5) with respect to the stacking direction (R),
wherein the control terminal (10) is electrically coupled to respective electric contacts (7, 8) of the semiconductor power devices (2), and
wherein the hollow housing (4) encloses the semiconductor power devices (2) such that the housing (4) and the first and the second metallic component (11, 12) form an inner flow chamber around the semiconductor power devices (2) which is configured to be filled with the cooling fluid during operation of the semiconductor power module (1).

3. Semiconductor power module (1) according to any of the preceding claims, wherein the housing (4) comprises an electrically insulating material with a predetermined dielectric strength and is made of or comprise polyether ether ketone, PEEK, polytetrafluoroethylene, PTFE, ceramic and/or an epoxy-based mold compound.

4. Semiconductor power module (1) according to any of the preceding claims, wherein the control terminal (10) and/or the second metallic component (12) are made of or comprise copper and/or aluminium.

5. Semiconductor power module (1) according to any of the preceding claims, wherein the first metallic component (11) is made of or comprise molybdenum and/or copper and/or aluminium.

6. Semiconductor power module (1) according to any of the preceding claims, comprising:
at least one metallic spring (8) that electrically connects a respective electrical contact (7) of the associated semiconductor power device (2) with the control terminal (10).

7. Semiconductor power module (1) according to any of the preceding claims, wherein the inlet (43) and the outlet (44) of the housing (4) are arranged at the same side (45) of the housing (4) such that the inner flow chamber and the inlet (43) and the outlet (44) form a U-shaped flow volume inside the semiconductor power module (1).

8. Semiconductor power module (1) according to any of the preceding claims, wherein the given surface structure (13) of the first metallic component (11) is formed at a side (15) facing the semiconductor power device (2) and comprises a plurality of ribs (17) and grooves (18) formed alternately side by side with respect to a lateral direction (A, B) perpendicular to the stacking direction (R).

9. Semiconductor power module (1) according to any of the preceding claims, comprising:
at least one sealing member (9) that is arranged between the housing (4) and the first and/or the second metallic component (11, 12) with respect to the stacking direction (R) such that an inner area of the housing (4) is sealed against an outer area of the housing (4).

10. Semiconductor power module (1) according to any of the preceding claims, wherein the respective semiconductor power device (2) is formed as at least one of a metal-oxide-semiconductor field effect transistor, MOSFET, and an insulated-gate bipolar transistor, IGBT.

11. Semiconductor power module (1) according to any of the preceding claims, wherein the second metallic component (12) comprises a recess (20) formed at a side (16) facing the semiconductor device (2) formed geometrically in coordination with the control terminal (10) such that the control terminal (10) is arranged inside the recess (20) between the second metallic component (12) and the respective semiconductor power device (2) with respect to the stacking direction (R).

12. Semiconductor power package, comprising:
- a semiconductor power module (1) according to any of the preceding claims, and
- a cooling fluid that is configured to flow through the inner flow chamber of the semiconductor power module (1) and around the respective semiconductor power device (2) during operation.

13. Semiconductor power package according to claim 12, wherein the cooling fluid comprises at least one of a dielectric strength above or equal to 10 kV/mm, a thermal conductivity in a range of 0.05 to 0.5 W/m K, a boiling point above 100 °C relating to a pressure at 1 atm, a viscosity less than or equal to 50 cSt and a specific heat above or equal to 700 J/kg·K.

14. Method for manufacturing a semiconductor power module (1) according to any of the claims 1-11, comprising:
- providing at least one semiconductor power device (2) having electrical terminals,
- providing a first metallic component (11) with a given surface structure (13) for guiding a cooling fluid along the semiconductor power device (2),
- providing a second metallic component (12) with a given surface structure (14) for guiding a cooling fluid along the semiconductor power device (2), wherein the first metallic component (11) forms a plate-like bottom and/or the second metallic component (12) forms a plate like top of the semiconductor power module (1) with respect to the stacking direction (R),
- coupling the semiconductor power device (2) and the first metallic component (11) to each other such that the first metallic component (11) is coupled to a first side (5) of the semiconductor power device (2),
- coupling the semiconductor power device (2) and the second metallic component (12) to each other such that the second metallic component (12) is coupled to a second side (6) of the semiconductor power device (2) opposite the first side (5) with respect to a stacking direction (R) of the semiconductor power module (1),
- providing a control terminal (10) and coupling the control terminal (10) electrically to an electrical contact (7) of the semiconductor power device (2),
- providing a hollow housing (4) that limits a predetermined inner flow for guiding the cooling fluid, wherein the housing (4) comprises an inlet (43) and an outlet (44) for the entering and exiting of the cooling fluid into and out of the housing (4), and
- coupling the housing (4) to both the first and the second metallic component (11, 12) such that the housing (4) encloses the semiconductor power device (2) and such that the housing (4) and the first and the second metallic component (11, 12) form an inner flow chamber around the semiconductor power device (2) which is filled with the cooling fluid during operation of the semiconductor power module (1).

## Patentansprüche

1. Halbleiterleistungsmodul (1), Folgendes umfassend:
- mindestens eine Halbleiterleistungsvorrichtung (2), die elektrische Anschlüsse aufweist,
- eine erste metallische Komponente (11), die mit einer ersten Seite (5) der Halbleiterleistungsvorrichtung (2) gekoppelt ist, wobei die erste metallische Komponente (11) eine gegebene Oberflächenstruktur (13) zum Führen eines Kühlfluids entlang der Halbleiterleistungsvorrichtung (2) umfasst,
- eine zweite metallische Komponente (12), die mit einer zweiten Seite (6) der Halbleiterleistungsvorrichtung (2) gekoppelt ist, die der ersten Seite (5) in Bezug auf eine Stapelrichtung (R) des Halbleiterleistungsmoduls (1) gegenüberliegt, wobei die zweite metallische Komponente (12) eine gegebene Oberflächenstruktur (14) zum Führen des Kühlfluids entlang der Halbleiterleistungsvorrichtung (2) umfasst,
- einen Steuerungsanschluss (10), der mit einem elektrischen Kontakt (7, 8) der Halbleiterleistungsvorrichtung (2) elektrisch verbunden ist, und
- ein hohles Gehäuse (4), das eine vorbestimmte innere Strömung des Kühlfluids begrenzt, wobei das Gehäuse (4) einen Einlass (43) und einen Auslass (44) für den Eintritt und den Austritt des Kühlfluids in das Gehäuse (4) und aus ihm heraus umfasst und wobei das Gehäuse (4) sowohl mit der ersten als auch mit der zweiten metallischen Komponente (11, 12) gekoppelt ist und die Halbleiterleistungsvorrichtung (2) umschließt, so dass das Gehäuse (4) und die erste und die zweite metallische Komponente (11, 12) eine innere Strömungskammer um die Halbleiterleistungsvorrichtung (2) herum ausbilden, die eingerichtet ist, um während des Betriebs des Halbleiterleistungsmoduls (1) mit dem Kühlfluid gefüllt zu werden, **dadurch gekennzeichnet, dass** die erste metallische Komponente (11) einen plattenförmigen Boden ausbildet und/oder die zweite metallische Komponente (12) eine plattenförmige Oberseite des Halbleiterleistungsmoduls (1) in Bezug auf die Stapelrichtung (R) ausbildet.

2. Halbleiterleistungsmodul (1) nach Anspruch 1, Folgendes umfassend:
mindestens zwei Halbleiterleistungsvorrichtungen (2), die jeweils elektrische Anschlüsse aufweisen,
wobei die erste metallische Komponente (11) mit einer jeweiligen ersten Seite (5) der Halbleiterleistungsvorrichtungen (2) gekoppelt ist, wobei die zweite metallische Komponente (12) mit einer jeweiligen zweiten Seite (6) der Halbleiterleistungsvorrichtungen (2) gekoppelt ist, die den ersten Seiten (5) in Bezug auf die Stapelrichtung (R) gegenüberliegt,
wobei der Steuerungsanschluss (10) mit jeweiligen elektrischen Kontakten (7, 8) der Halbleiterleistungsvorrichtungen (2) elektrisch verbunden ist und
wobei das hohle Gehäuse (4) die Halbleiterleistungsvorrichtungen (2) umschließt, so dass das Gehäuse (4) und die erste und die zweite metallische Komponente (11, 12) eine innere Strömungskammer um die Halbleiterleistungsvorrichtungen (2) herum ausbilden, die eingerichtet ist, um beim Betrieb des Halbleiterleistungsmoduls (1) mit dem Kühlfluid gefüllt zu werden.

3. Halbleiterleistungsmodul (1) nach einem der vorhergehenden Ansprüche, wobei das Gehäuse (4) ein elektrisch isolierendes Material mit einer vorbestimmten Isolationsstärke umfasst und aus Polyetheretherketon, PEEK, Polytetrafluorethylen, PTFE, Keramik und/oder einer Epoxidbasierten Formmasse angefertigt ist oder diese umfasst.

4. Halbleiterleistungsmodul (1) nach einem der vorhergehenden Ansprüche, wobei der Steuerungsanschluss (10) und/oder die zweite metallische Komponente (12) aus Kupfer und/oder Aluminium angefertigt sind oder diese umfassen.

5. Halbleiterleistungsmodul (1) nach einem der vorhergehenden Ansprüche, wobei die erste metallische Komponente (11) aus Molybdän und/oder Kupfer und/oder Aluminium angefertigt ist oder diese umfasst.

6. Halbleiterleistungsmodul (1) nach einem der vorhergehenden Ansprüche, Folgendes umfassend:
mindestens eine metallische Feder (8), die einen jeweiligen elektrischen Kontakt (7) der dazugehörigen Halbleiterleistungsvorrichtung (2) mit dem Steuerungsanschluss (10) elektrisch verbindet.

7. Halbleiterleistungsmodul (1) nach einem der vorhergehenden Ansprüche, wobei der Einlass (43) und der Auslass (44) des Gehäuses (4) auf der gleichen Seite (45) des Gehäuses (4) angeordnet sind, so dass die innere Strömungskammer und der Einlass (43) und der Auslass (44) ein U-förmiges Strömungsvolumen in dem Halbleiterleistungsmodul (1) ausbilden.

8. Halbleiterleistungsmodul (1) nach einem der vorhergehenden Ansprüche, wobei die gegebene Oberflächenstruktur (13) der ersten metallischen Komponente (11) auf einer Seite (15) ausgebildet ist, die der Halbleiterleistungsvorrichtung (2) zugewandt ist, und eine Vielzahl von Rippen (17) und Nuten (18) umfasst, die abwechselnd Seite an Seite in Bezug auf eine laterale Richtung (A, B) senkrecht zu der Stapelrichtung (R) ausgebildet sind.

9. Halbleiterleistungsmodul (1) nach einem der vorhergehenden Ansprüche, Folgendes umfassend:
mindestens ein Dichtungselement (9), das zwischen dem Gehäuse (4) und der ersten und/oder der zweiten metallischen Komponente (11, 12) in Bezug auf die Stapelrichtung (R) angeordnet ist, so dass ein Innenbereich des Gehäuses (4) gegen einen Außenbereich des Gehäuses (4) gedichtet ist.

10. Halbleiterleistungsmodul (1) nach einem der vorhergehenden Ansprüche, wobei die jeweilige Halbleiterleistungsvorrichtung (2) als mindestens eine von einem Metalloxid-Halbleiter-Feldeffekttransistor, MOSFET, und einem Bipolartransistor mit isoliertem Gate, IGBT, ausgebildet ist.

11. Halbleiterleistungsmodul (1) nach einem der vorhergehenden Ansprüche, wobei die zweite metallische Komponente (12) eine Aussparung (20) umfasst, die auf einer Seite (16) ausgebildet ist, die der Halbleitervorrichtung (2) zugewandt ist und die geometrisch in Abstimmung mit dem Steuerungsanschluss (10) ausgebildet ist, so dass der Steuerungsanschluss (10) in der Aussparung (20) zwischen der zweiten metallischen Komponente (12) und der jeweiligen Halbleiterleistungsvorrichtung (2) in Bezug auf die Stapelrichtung (R) angeordnet ist.

12. Halbleiterleistungspaket, Folgendes umfassend:
- ein Leistungshalbleitermodul (1) nach einem der vorhergehenden Ansprüche und
- ein Kühlfluid, das eingerichtet ist, um beim Betrieb durch die innere Strömungskammer des Halbleiterleistungsmoduls (1) und um die jeweilige Halbleiterleistungsvorrichtung (2) herum zu strömen.

13. Halbleiterleistungspaket nach Anspruch 12, wobei das Kühlfluid mindestens eines von einer Isolationsstärke von mehr als oder gleich 10 kV/mm, einer Wärmeleitfähigkeit in einem Bereich von 0,05 bis 0,5 W/m·K, einem Siedepunkt über 100 °C in Bezug auf einen Druck von 1 atm, einer Viskosität von weniger als oder gleich 50 cSt und einer spezifischen Wärme von mehr als oder gleich 700 J/kg·K umfasst.

14. Verfahren zum Herstellen eines Halbleiterleistungsmoduls (1) nach einem der Ansprüche 1 bis 11, Folgendes umfassend:
- Bereitstellen mindestens einer Halbleiterleistungsvorrichtung (2), die elektrische Anschlüsse aufweist,
- Bereitstellen einer ersten metallischen Komponente (11) mit einer gegebenen Oberflächenstruktur (13) zum Führen eines Kühlfluids entlang der Halbleiterleistungsvorrichtung (2),
- Bereitstellen einer zweiten metallischen Komponente (12) mit einer gegebenen Oberflächenstruktur (14) zum Führen eines Kühlfluids entlang der Halbleiterleistungsvorrichtung (2), wobei die erste metallische Komponente (11) einen plattenförmigen Boden ausbildet und/oder die zweite metallische Komponente (12) eine plattenförmige Oberseite des Halbleiterleistungsmoduls (1) in Bezug auf die Stapelrichtung (R) ausbildet,
- Koppeln der Halbleiterleistungsvorrichtung (2) und der ersten metallischen Komponente (11) miteinander, so dass die erste metallische Komponente (11) mit einer ersten Seite (5) der Halbleiterleistungsvorrichtung (2) gekoppelt ist,
- Koppeln der Halbleiterleistungsvorrichtung (2) und der zweiten metallischen Komponente (12) miteinander, so dass die zweite metallische Komponente (12) mit einer zweiten Seite (6) der Halbleiterleistungsvorrichtung (2) gekoppelt ist, die der ersten Seite (5) in Bezug auf eine Stapelrichtung (R) des Halbleiterleistungsmoduls (1) gegenüberliegt,
- Bereitstellen eines Steuerungsanschlusses (10) und Koppeln des Steuerungsanschlusses (10) mit einem elektrischen Kontakt (7) der Halbleiterleistungsvorrichtung (2),
- Bereitstellen eines hohlen Gehäuses (4), das eine vorbestimmte innere Strömung zum Führen des Kühlfluids begrenzt, wobei das Gehäuse (4) einen Einlass (43) und einen Auslass (44) für den Eintritt und den Austritt des Kühlfluids in das Gehäuse (4) und aus ihm heraus umfasst, und
- Koppeln des Gehäuses (4) sowohl mit der ersten als auch mit der zweiten metallischen Komponente (11, 12), so dass das Gehäuse (4) die Halbleiterleistungsvorrichtung (2) umschließt und so dass das Gehäuse (4) und die erste und die zweite metallische Komponente (11, 12) eine innere Strömungskammer um die Halbleiterleistungsvorrichtung (2) herum ausbilden, die beim Betrieb des Halbleiterleistungsmoduls (1) mit dem Kühlfluid gefüllt ist.

## Revendications

1. Module semi-conducteur de puissance (1), comprenant :
- au moins un dispositif semi-conducteur de puissance (2) comportant des bornes électriques,
- un premier composant métallique (11) couplé à un premier côté (5) du dispositif semi-conducteur de puissance (2), le premier composant métallique (11) comprenant une structure de surface donnée (13) destinée à guider un fluide de refroidissement le long du dispositif semi-conducteur de puissance (2),
- un deuxième composant métallique (12) couplé à un deuxième côté (6) du dispositif semi-conducteur de puissance (2) à l'opposé du premier côté (5) par rapport à une direction d'empilement (R) du module semi-conducteur de puissance (1), le deuxième composant métallique (12) comprenant une structure de surface donnée (14) destinée à guider le fluide de refroidissement le long du dispositif semi-conducteur de puissance (2),
- une borne de commande (10) couplée électriquement à un contact électrique (7, 8) du dispositif semi-conducteur de puissance (2), et
- un boîtier creux (4) limitant une circulation interne prédéterminée du fluide de refroidissement, le boîtier (4) comprenant une entrée (43) et une sortie (44) pour l'entrée et la sortie du fluide de refroidissement dans le et hors du boîtier (4) et le boîtier (4) étant couplé à la fois au premier et au deuxième composant métallique (11, 12) et entourant le dispositif semi-conducteur de puissance (2), de sorte que le boîtier (4) et le premier et le deuxième composant métallique (11, 12) forment autour du dispositif semi-conducteur de puissance (2) une chambre de circulation interne qui est conçue pour être remplie avec le liquide de refroidissement pendant le fonctionnement du module semi-conducteur de puissance (1), **caractérisé en ce que** le premier composant métallique (11) forme un fond en forme de plaque et/ou le deuxième composant métallique (12) forme un sommet en forme de plaque du module semi-conducteur de puissance (1) par rapport à la direction d'empilement (R).

2. Module semi-conducteur de puissance (1) selon la revendication 1, comprenant :
au moins deux dispositifs semi-conducteurs de puissance (2) comportant chacun des bornes électriques,
dans lequel le premier composant métallique (11) est couplé à un premier côté respectif (5) des dispositifs semi-conducteurs de puissance (2), dans lequel le deuxième composant métallique (12) est couplé à un deuxième côté respectif (6) des dispositifs semi-conducteurs de puissance (2) à l'opposé des premiers côtés (5) par rapport à la direction d'empilement (R),
dans lequel la borne de commande (10) est couplée électriquement à des contacts électriques respectifs (7, 8) des dispositifs semi-conducteurs de puissance (2), et
dans lequel le boîtier creux (4) entoure les dispositifs semi-conducteurs de puissance (2), de sorte que le boîtier (4) et le premier et le deuxième composant métallique (11, 12) forment autour des dispositifs semi-conducteurs de puissance (2) une chambre de circulation interne qui est conçue pour être remplie avec le fluide de refroidissement pendant le fonctionnement du module semi-conducteur de puissance (1).

3. Module semi-conducteur de puissance (1) selon l'une quelconque des revendications précédentes, dans lequel le boîtier (4) comprend un matériau électriquement isolant avec une rigidité diélectrique prédéterminée et est constitué de polyétheréthercétone, PEEK, de polytétrafluoroéthylène, PTFE, d'une céramique et/ou d'un composé de moulage à base de résine époxy, ou en comprend.

4. Module semi-conducteur de puissance (1) selon l'une quelconque des revendications précédentes, dans lequel la borne de commande (10) et/ou le deuxième composant métallique (12) sont constitués de cuivre et/ou d'aluminium ou en comprennent.

5. Module semi-conducteur de puissance (1) selon l'une quelconque des revendications précédentes, dans lequel le premier composant métallique (11) est constitué de molybdène et/ou de cuivre et/ou d'aluminium, ou en comprend.

6. Module semi-conducteur de puissance (1) selon l'une quelconque des revendications précédentes, comprenant :
au moins un ressort métallique (8) qui relie électriquement un contact électrique respectif (7) du dispositif semi-conducteur de puissance (2) associé à la borne de commande (10).

7. Module semi-conducteur de puissance (1) selon l'une quelconque des revendications précédentes, dans lequel l'entrée (43) et la sortie (44) du boîtier (4) sont disposées sur le même côté (45) du boîtier (4), de sorte que la chambre de circulation interne et l'entrée (43) et la sortie (44) forment un volume de circulation en forme de U à l'intérieur du module semi-conducteur de puissance (1).

8. Module semi-conducteur de puissance (1) selon l'une quelconque des revendications précédentes, dans lequel la structure de surface donnée (13) du premier composant métallique (11) est formée sur un côté (15) faisant face au dispositif semi-conducteur de puissance (2) et comprend une pluralité de nervures (17) et de rainures (18) formées en alternance côte à côte par rapport à une direction latérale (A, B) perpendiculaire à la direction d'empilement (R).

9. Module semi-conducteur de puissance (1) selon l'une quelconque des revendications précédentes, comprenant :
au moins un élément d'étanchéité (9) qui est disposé entre le boîtier (4) et le premier et/ou le deuxième composant métallique (11, 12) par rapport à la direction d'empilement (R), de sorte qu'une zone interne du boîtier (4) est rendue étanche par rapport à une zone externe du boîtier (4).

10. Module semi-conducteur de puissance (1) selon l'une quelconque des revendications précédentes, dans lequel le dispositif semi-conducteur de puissance (2) respectif est formé comme un transistor à effet de champ métal-oxyde-semi-conducteur, MOSFET, et/ou un transistor bipolaire à grille isolée, IGBT.

11. Module semi-conducteur de puissance (1) selon l'une quelconque des revendications précédentes, dans lequel le deuxième composant métallique (12) comprend une encoche (20) formée sur un côté (16) faisant face au dispositif semi-conducteur (2) formée géométriquement en coordination avec la borne de commande (10), de sorte que la borne de commande (10) est disposée à l'intérieur de l'encoche (20) entre le deuxième composant métallique (12) et le dispositif semi-conducteur de puissance (2) respectif par rapport à la direction d'empilement (R).

12. Boîtier semi-conducteur de puissance, comprenant :
- un module semi-conducteur de puissance (1) selon l'une quelconque des revendications précédentes, et
- un fluide de refroidissement qui est conçu pour circuler à travers la chambre de circulation interne du module semi-conducteur de puissance (1) et autour du dispositif semi-conducteur de puissance (2) respectif en fonctionnement.

13. Boîtier semi-conducteur de puissance selon la revendication 12, dans lequel le fluide de refroidissement possède au moins un paramètre parmi une rigidité diélectrique supérieure ou égale à 10 kV/mm, une conductivité thermique dans une plage de 0,05 à 0,5 W/m K, un point d'ébullition supérieur à 100 °C sous une pression de 1 atm, une viscosité inférieure ou égale à 50 cSt et une chaleur spécifique supérieure ou égale à 700 J/kg·K.

14. Procédé destiné à fabriquer un module semi-conducteur de puissance (1) selon l'une quelconque des revendications 1 à 11, comprenant :
- l'obtention d'au moins un dispositif semi-conducteur de puissance (2) comportant des bornes électriques,
- l'obtention d'un premier composant métallique (11) avec une structure de surface donnée (13) destinée à guider un fluide de refroidissement le long du dispositif semi-conducteur de puissance (2),
- l'obtention d'un deuxième composant métallique (12) avec une structure de surface donnée (14) destinée à guider un fluide de refroidissement le long du dispositif semi-conducteur de puissance (2), le premier composant métallique (11) formant un fond en forme de plaque et/ou le deuxième composant métallique (12) formant un sommet en forme de plaque du module semi-conducteur de puissance (1) par rapport à la direction d'empilement (R),
- le couplage du dispositif semi-conducteur de puissance (2) et du premier composant métallique (11) l'un à l'autre de telle sorte que le premier composant métallique (11) soit couplé à un premier côté (5) du dispositif semi-conducteur de puissance (2),
- le couplage du dispositif semi-conducteur de puissance (2) et du deuxième composant métallique (12) l'un à l'autre de telle sorte que le deuxième composant métallique (12) soit couplé à un deuxième côté (6) du dispositif semi-conducteur de puissance (2) à l'opposé du premier côté (5) par rapport à une direction d'empilement (R) du module semi-conducteur de puissance (1),
- l'obtention d'une borne de commande (10) et le couplage électrique de la borne de commande (10) à un contact électrique (7) du dispositif semi-conducteur de puissance (2),
- l'obtention d'un boîtier creux (4) qui limite une circulation interne prédéterminée afin de guider le fluide de refroidissement, le boîtier (4) comprenant une entrée (43) et une sortie (44) pour l'entrée et la sortie du fluide de refroidissement dans le et hors du boîtier (4), et
- le couplage du boîtier (4) à la fois au premier et au deuxième composant métallique (11, 12) de telle sorte que le boîtier (4) entoure le dispositif semi-conducteur de puissance (2) et de telle sorte que le boîtier (4) et le premier et le deuxième composant métallique (11, 12) forment une chambre de circulation interne autour du dispositif semi-conducteur de puissance (2) qui est remplie avec le liquide de refroidissement pendant le fonctionnement du module semi-conducteur de puissance (1).
